# EUROPÄISCHE PATENTSCHRIFT

(11) **EP 0 840 896 B1**
(45) Veröffentlichungstag und Bekanntmachung des Hinweises auf die Patenterteilung: **19.12.2001**
(21) Anmeldenummer: 96923844.3
(22) Anmeldetag: 15.07.1996
(51) Int. Cl.: G01R 21/133

(54) **ELEKTRIZITÄTSZÄHLER**
ELECTRICITY METER
COMPTEUR ELECTRIQUE

(30) Priorität: 21.07.1995 DE 19526723
(43) Veröffentlichungstag der Anmeldung: 13.05.1998
(73) Patentinhaber: SIEMENS AKTIENGESELLSCHAFT, 80333 München (DE)
(72) Erfinder: WINDSHEIMER, Klaus, D-91174 Spalt (DE)
(86) Internationale Anmeldenummer: DE9601280
(87) Internationale Veröffentlichungsnummer: WO9704321

(56) Entgegenhaltungen:
- EP-A- 0 575 622
- EP-A- 0 634 662
- DE-A- 4 021 522
- IEEE JOURNAL OF SOLID-STATE CIRCUITS, Bd. 26, Nr. 12, Dezember 1991, NEW YORK,US, Seiten 2008-2015, XP000272862 GARVERICK ET AL.: "a programmable mixed-signal asic for power metering"

## Beschreibung

Die Erfindung bezieht sich auf einen Elektrizitätszähler welcher Sigma-Delta-Modulatoren und eine digitale Signalverarbeitungseinrichtung aufweist.

Aus der DE 40 21 522 A1 ist ein elektronischer Schalter bekannt, der je zu erfassender Netzphase einen Sigma-Delta-Modulator (ΣΔ-Modulator)umfaßt, welchem ein Dezimationsfilter nachgeschaltet ist. Die Ausgänge der Dezimationsfilter sind über eine Schaltlogik miteinander verknüpft, deren Ausgang auf ein Stellglied zum Unterbrechen der Stromzufuhr geführt ist. Dieser Schalter dient dazu, einen Überstrom zu erfassen und bei einem vorgegebenen Grenzwert eine Abschaltung zu erzielen. Bei einem Fehler innerhalb einer der Signalkanäle, z. B. einer Unterbrechung, kann gegebenenfalls kein Überstrom erfaßt werden, so daß auch eine Auslösung nicht möglich ist.

Aus der EP 0 634 662 A1 ist ein Elektrizitätszähler bekannt, welcher Signalkanäle mit Multiplexern aufweist, auf deren Eingänge mittels Wandler erfaßte Strom- und Spannungssignale eines Verbrauchers geschaltet sind. Weiterhin sind dort Sigma-Delta-Modulatoren und eine digitale Signalverarbeitungseinrichtung vorgesehen.

Der Erfindung liegt ausgehend von diesem Stand der Technik die Aufgabe zugrunde, einen Elektrizitätszähler anzugeben, bei dem eine weitgehende Selbstüberwachung für seine Meßkanäle gegeben ist.

Die Aufgabe wird erfindungsgemäß gelöst mit einem Elektrizitätszähler mit drei Signalkanälen, die auf eine digitale Signalverarbeitungseinrichtung geführt sind, wobei jeder Signalkanal folgende Mittel umfaßt:
- einen Multiplexer, auf dessen Eingänge mittels Wandlern erfaßte Strom- und/oder Spannungssignale eines elektrischen Verbrauchers geschaltet sind,
- einen dem Multiplexer nachgeschalteten ΣΔ-Modulator,
- wobei auf den ersten und zweiten Signalkanal Spannungs- bzw. Stromsignale und auf den dritten Signalkanal dieselben Signale und gegebenenfalls weitere Signale geschaltet sind, und
- wobei in der digitalen Signalverarbeitungseinrichtung (DS) ein Vergleich von Daten gleicher Signale erfolgt, die von unterschiedlichen Signalkanälen bereitgestellt werden, und beim Auftreten einer Signalabweichung, die einen vorgegebenen ersten Wert überschreitet, ein Fehlersignal erzeugt wird.

Auf diese Weise können Fehler innerhalb der einzelnen Meßkanäle zuverlässig erkannt werden. Dabei werden die den jeweiligen unterschiedlichen Signalkanälen zugeordneten Signale zur Bildung von Vergleichswerten verwendet, so daß eine Plausiblitätskontrolle der erfaßten Meßwerte oder Signale möglich ist. Auf diese Weise kann beispielsweise festgestellt werden, ob ein interner oder externer Fehler vorliegt, wobei durch logische Verknüpfungen in der DS gegebenenfalls eine nähere Eingrenzung oder Lokalisierung des Fehlers möglich ist. Durch die Redundanz bei der Signalerfassung über verschiedene Signalkanäle ist eine hohe Sicherheit bei der Meßwertverarbeitung gegeben. Ein Ausfall eines Kanals wird zuverlässig erkannt.

Eine Erweiterung der Signalverarbeitung ist dadurch erzielt, daß zwischen dem dritten Multiplexer und der DS ein vierter Multiplexer geschaltet ist, auf dessen weiteren Eingängen gegebenenfalls nochmals die weiteren Signale geführt sind.

Mit Vorteil ist zumindest den ersten drei Multiplexern zusätzlich ein Erd- oder Massepotential als Eingangssignal zugeführt. Dadurch ist es auf einfache Weise möglich, einen Offset-Fehler des jeweiligen Meßkanals, insbesondere des ΣΔ-Modulators, zu erfassen.

Als weitere Signale können bevorzugt eine Hilfsspannung, ein Hilfs- oder Nulleiterstrom, ein Temperatur- oder ein Spannungssignal vorgesehen sein. Diese Signale können in der DS ebenfalls einer Meßwertüberwachung unterzogen werden oder als Vergleichsignal oder Referenz für die übrigen Signale dienen. Dadurch sind auch weitere Vergleiche zwischen Signalen möglich, wobei durch zusätzliche Plausibilitätskontrollen eine gute Selbstüberwachung des Zählers gegeben ist.

Es ist von Vorteil, wenn in der DS mit Hilfe eines Oszillators, insbesondere eines Quarzoszillators, die Netzfrequenz der erfaßten Spannungsignale gemessen wird. Bei Überschreiten eines vorgegebenen Frequenzgrenzwertes wird ein Fehlersignal erzeugt. Üblicherweise kann davon ausgegangen werden, daß die mit der Spannung erfaßte Netzfrequenz relativ konstant ist und innerhalb bestimmter Grenzen liegt. Bei einer unzulässig großen Abweichung der gemessenen Netzfrequenz von ihrem Sollwert kann daher auf ein Fehler des Oszillators oder im Programmablauf in der DS geschlossen werden.

Es ist günstig, wenn von den im zweiten Signalkanal erfaßten Stromsignalen eine erste Summe gebildet und mit einem Stromgrenzwert verglichen wird und bei Überschreiten des Stromgrenzwertes ein drittes Fehlersignal erzeugt wird. Dadurch sind Unsymmetrien in der Signalverarbeitung erfaßbar. Gegebenenfalls kann mit Vorteil zu der ersten Summe der Ströme zusätzlich noch ein Nulleiterstrom addiert sein. Dies ist insbesondere bei Anwendungen in Ländern günstig, in denen der Nulleiterstrom zugänglich ist oder gemessen werden soll.

Bevorzugt sind die Multiplexer miteinander synchronisiert. Dadurch ist ein Vergleich von zeitgleichen Meßwerten oder Signalen möglich. Dies gilt insbesondere für die Bildung von Zählwerten bei einer Verbrauchsmessung und für die Überwachung des Zählers. Bevorzugt ist die Anzahl der Eingänge der jeweiligen Multiplexer für die Erfassung von dreiphasigen Netzwerten - entsprechend einem dreiphasigen Drehstromnetz - angepaßt.

Mit Vorteil ist zwischen den ΣΔ-Modulatoren und der DS jeweils ein Dezimationsfilter geschaltet. Auf diese Weise werden die von den ΣΔ-Modulatoren abgegebenen Bitströme mit der -je nach Anforderung- gewünschten Auflösung als digitale Worte für die weitere Signalverarbeitung zur Verfügung gestellt. Je nach Auslegung des Filters kann dabei beispielsweise eine hohe Auflösung oder eine schnelle Signalverarbeitung erzielt werden. Das Dezimationsfilter kann dazu per Soft- oder Hardware einstellbar sein, wodurch gegebenenfalls auch weitere Anwendungsmöglichkeiten oder Anwendungsgebiete für den Zähler gegeben sind.

Es ist günstig, wenn in der DS in Abhhängigkeit von zumindest einem der Fehlersignale ein Ausfall einer der Signalkanäle erfaßt wird und im Fehlerfall das dadurch jeweils fehlende Signal über einen der intakten Signalkanäle erfaßt wird. Damit ist im Fehlerfall quasi ein unterbrechungsfreier Betrieb des Zählers möglich. Das gewünschte Signal wird einfach über einen intakten Signalkanal erfaßt und der Signalverarbeitung zugeführt, wodurch kein Verlust von zu erfassenden Verbrauchswerten gegeben ist.

Ein Ausführungsbeispiel der Erfindung, weitere Vorteile und Details werden nachfolgend anhand der Zeichnung beispielhaft näher erläutert. Es zeigt:

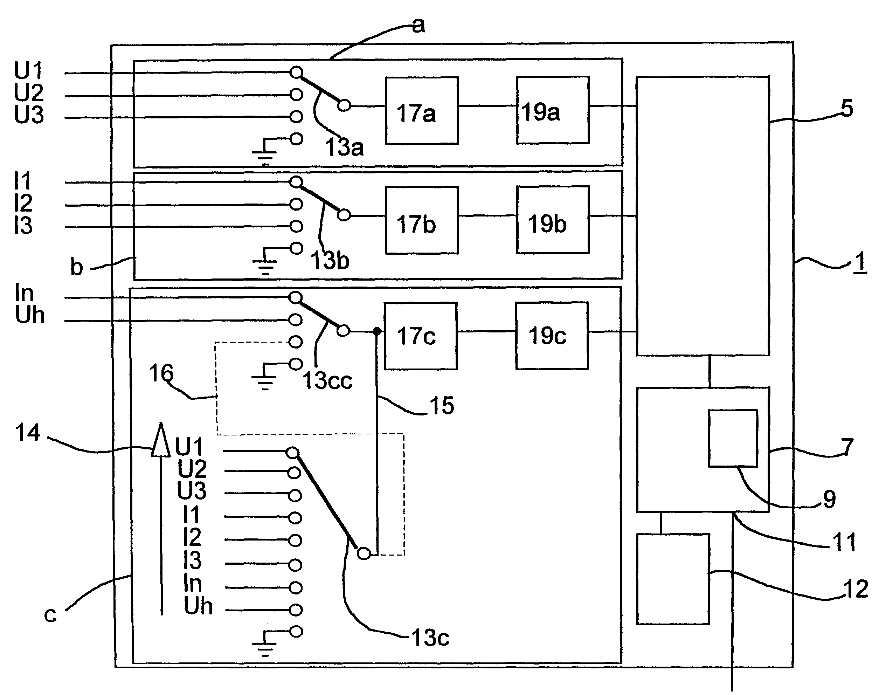

FIG 1 ein Blockschaltbild eines Elektrizitätszählers.

Nachfolgend sind gleiche Details mit gleichen Bezugszeichen versehen, wobei gleiche Details unterschiedlicher Gruppen durch zusätzliche Buchstaben entsprechend dem jeweiligen Signalkanal a,b,c voneinander unterschieden werden.

FIG 1 zeigt ein Blockschaltbild eines Elektrizitätszählers (Zähler 1) mit drei Signalkanälen a,b,c, die auf eine gemeinsame digitale Signalverarbeitungseinrichtung, nachfolgend DS 5 genannt, geführt sind. In der DS 5 erfolgt eine Meßwertverarbeitung zur Verbrauchsmessung und für weitere Funktionen des Zählers 1. Die DS 5 ist bevorzugt als digitaler Signalprozessor ausgebildet. Sie kann jedoch auch als Recheneinrichtung mit einem Mikrocomputer oder als festverdrahtete Logikschaltung ausgeführt sein. Wesentlich ist dabei, daß eine digitale Signalbearbeitung der von den Signalkanälen a,b,c bereitgestellten Signalen oder Daten möglich ist.

Der DS 5 ist gegebenenfalls noch eine weitere Anordnung 7 nachgeschaltet, die Anzeigemittel 9 und/oder eine Schnittstelle 11 umfaßt. Die Anordnung 7 kann dabei beispielsweise als digitale Verarbeitungsanordnung mit einem Mikroprozessor ausgebildet sein. Es ist auch denkbar, daß die DS 5 und die Anordnung 7 eine Baueinheit bilden oder von einem gemeinsamen Bauteil, insbesondere einem Rechner, gebildet sind. Speziell können alle in der FIG gezeigten Komponenten des Zählers 1 auf oder in einem Bauteil, insbesondere einem IC oder ASIC, vereinigt sein. Gegebenenfalls kann der Anordnung 7 auch eine weitere Einrichtung 12 zugeordnet sein, die für den Betrieb benötigte Hilfseinrichtung, z.B. Speicher, einen Oszillator, einen Rechner oder Ein/Ausgabemittel, umfaßt.

Der erste Signalkanal a ist vorliegend als Spannungskanal, der zweite Signalkanal b als Stromkanal und der dritte Signalkanal c als Kanal für weitere Signale oder Hilfsgrößen ausgebildet. Vorliegend wird davon ausgegangen, daß dreiphasige Signale von einem entsprechenden Verbraucher oder Netz verarbeitet werden. Dem ersten Signalkanal a sind daher die Spannungssignale U1 bis U3 zugeführt. Der zweite Signalkanal b erhält die Stromsignale I1 bis I3 der jeweiligen Phasen. Ein Einsatz bei Verbrauchern mit mehr oder weniger Phasen ist - gegebenenfalls mit entsprechenden Anpassungen - sinngemäß möglich.

Auf den dritten Signalkanal c sind weitere Signale In, Un geschaltet. Als weitere Signale können beliebige zu überwachende Signale dienen, z.B. ein Temperatursignal oder ein sonstiges Spannungs- oder Stromsignal. In der FIG ist beispielhaft dem dritten Signalkanal c ein Nulleiterstrom In und eine Spannung Uh zugeführt. Zusätzlich sind auch dem dritten Signakanal c die Strom- und Spannungssignale I1 bis I3 und U1 bis U3. Damit sind diese Signale doppelt oder redundant erfaßt.

Die jeweiligen obengenannten Signale sind jeweils auf nicht näher bezeichnete Eingänge von Multiplexern 13a bis 13c eines jeden Signalkanals a,b,c geführt. Zweckmäßigerweise ist die parallele Aufschaltung von Signalen auf mehrere Multiplexer durch eine nicht näher dargestellte interne Verschaltung (durch Pfeil 14 angedeutet) im Zähler 1 , z.B. durch eine entsprechende Verdrahtung auf einer Leiterplatte, realisiert. Selbstverständlich ist auch eine externe Verschaltung, z.B. auf einem Klemmenblock, möglich. Nachfolgend wird nun beispielhaft für alle Signalkanäle a,b,c der Signalkanal a beschrieben.

Dem Multiplexer 13a ist zur Analog/Digital-Wandlung ein ΣΔ-Modulator 17a nachgeschaltet. Zwischen dem ΣΔ-Modulator 17a und dem DS 5 ist bevorzugt ein Dezimationsfilter 19a geschaltet, das das digitale Ausgangssignal des ΣΔ-Modulators 17a für den DS 5 aufbereitet. Dies kann in besonderen Fällen auch entfallen oder gegebenenfalls im DS 5 funktionell enthalten sein.

Der Multiplexer 13a tastet zyklisch die Spannungssignale U1,U2,U3 ab. Die Abtastung erfolgt dabei mit einer ausreichend hohen Frequenz, so daß eine entsprechende Auflösung gewährleistet ist. Die Abtastfrequenz kann beispielsweise zwischen 200 Hz und 20 kHz, bevorzugt zwischen 1 und 5 kHz, liegen.

Der zweite Signalkanal b ist in seinem Aufbau mit dem des ersten Signalkanals a identisch. Der dritte Signalkanal c weist dagegen einen Multiplexer 13c mit höherer Eingangsanzahl auf, so daß die redundante Verarbeitung der Signale U1 bis U3 und I1 bis I3 möglich ist.

Dem dritten Multiplexer 13c des Signalkanals 3c kann zusätzlich auch ein vierter Multiplexer 13cc kaskadenartig nachgeschaltet sein. Bei dieser Alternative ist dann die Verbindungsleitung 15 durch die strichliert gezeichnete Leitung 16 ersetzt. Dem vierten Multiplexer 13cc können dann die lediglich dem dritten Multiplexer 13c zugeführten weiteren Signale Uh und In nochmals zugeführt werden. Dadurch ist auch für die weiteren Signale Uh und In zumindest für einen Teilbereich quasi eine redundante Signalverarbeitung gegeben. Die jeweiligen nicht näher bezeichneten Eingänge der mit jeweils denselben Signalen beaufschlagten Multiplexern 13c und 13cc sind hierzu - wie bereits auch schon oben beschrieben - ebenfalls parallel geschaltet.

Die Multiplexer 13a bis 13cc sind bevorzugt miteinander synchronisiert, so daß später im DS 5 ein direkter Vergleich der redundant erfaßten Signale ohne Phasenverschiebung erfolgen kann. Ein unsynchronisierter Betrieb ist auch denkbar. In einem solchen Fall sind dann gegebenenfalls die jeweiligen digitalisierten Signale zwischenzuspeichern und einander zuzuordnen, wodurch der technische Aufwand leicht erhöht ist. Bei einem Vergleich von Effektivwerten der Signale ist eine Zwischenspeicherung nicht nötig.

Wahlweise kann den jeweiligen Multiplexern 13a bis 13cc zusätzlich ein Masse- oder Erdpotential als Eingangssignal zugeführt sein (in der FIG als Erdzeichen dargestellt). Auf diese Weise kann die Meßwertabweichung (Offset) in den einzelnen Signalkanälen a bis c auf einfache Weise ermittelt werden. Der ermittelte Meßfehler kann dann zum Abgleich oder zur Korrektur in der Signalverarbeitung verwendet werden. Bevorzugt kann die Überwachung der Meßwertabweichung zyklisch erfolgen, wodurch eine ständige Selbstüberwachung der jeweiligen Signalkanäle a bis c gegeben ist. Gegebenenfalls kann das Feststellen eines Meßfehlers auch zur Erzeugung eines Meldesignals verwendet werden, welches eine vorzeitige Wartung, Kalibrierung oder Eichung signalisiert. Die Korrektur kann gegebenenfalls im DS 5 oder in der Anordnung 7 erfolgen.

Die von den Signalkanälen a bis c erfaßten und vorverarbeiteten Signale werden nachfolgend im DS 5 weiterbehandelt. Im DS 5 sind dazu verschiedene Funktionen bevorzugt als Programm hinterlegt und realisiert.

### Meßwertüberwachung

Wichtige elektrische Signale, z. B. die Strom- und Spannungssignale I1 bis I3 bzw. U1 bis U3, werden in den unterschiedlichen Signalkanälen a bis c redundant erfaßt. Im DS 5 werden nun gleiche Signale miteinander verglichen und auf Plausiblität untersucht. Dazu kann beispielsweise aus den jeweiligen mittels des ΣΔ-Modulators 17a 17c gebildeten digitalen Abtastwerten der Spannungssignale U1 bis U3 die Effektivwerte der Spannung berechnet werden. Weichen die Effektivwerte der beiden Signalkanäle (in diesem Beispiel a und c) um einen vorgegebenen Betrag oder um einem vorgegebenen Grenzwert voneinander ab, so wird ein erstes Fehlersignal erzeugt. Es kann dann davon ausgegangen werden, daß zumindest einer der Signalkanäle fehlerhaft ist.

Dies ist beispielsweise dann der Fall, wenn alle Signale eines Signalkanals und von den Signalen eines anderen Signalkanals abweichen. Ist eine Abweichung nur bei einem Signal einer Phase gegeben, so kann daraus geschlossen werden, daß zumindest der jeweilige ΣΔ-Modulator und das jeweilige Dezimationsfilter korrekt arbeiten. Eine Fehlerquelle kann dann beispielsweise der Multiplexer sein.

Es können auch beispielsweise folgende Fehler erkannt werden: Eine Unterbrechung eines Bonddrahtes, ein Defekt des Spannungswandlers oder des Spannungsteilers, eine Unterbrechung der Zuleitung, eine fehlerhafte interne Verdrahtung oder ein fehlerhafter Anschluß des Zählers.

Die benötigte Plausiblitätskontrolle erfolgt selbstverständlich für alle eingangsseitig aufgeschalteten Signale. Gegebenenfalls kann auch ein Vergleich der Spannungs- oder Stromsignale U1 bis U3 bzw. I1 bis I3 mit einer Referenz- oder Hilfsgröße, die auf den dritten Signalkanal c geschaltet ist, erfolgen. Dazu kann beispielsweise die Spannung Uh als Referenzspannung dienen. Die Plausibilitätskontrolle kann als Programm im DS 5 oder auch als konkrete Schaltung oder Logik realisiert sein.

### Frequenzüberwachung

In der DS 5 wird die Netzfrequenz der erfaßten Signale, insbesondere der Spannungssignale U1 bis U3, mit Hilfe eines Quarzoszillators gemessen. Sollte die Netzfrequenz um einen bestimmten Betrag, beispielsweise 5 %, von der Sollfrequenz abweichen, so wird ein zweites Fehlersignal, insbesondere ein Fehlerflag, erzeugt. Die Netzfrequenz von Drehstromnetzen kann in der Regel als sehr konstant angesehen werden. Wird hier eine erhebliche Frequenzabweichung festgestellt, so kann davon ausgegangen werden, daß der Quarzoszillator fehlerhaft arbeitet. Dies kann als grobe Funktionskontrolle dienen, wobei insbesondere der Fehlerfall erfaßt wird, bei dem der Quarzoszillator auf einer Oberwelle schwingt.

### Nulleiterstromüberwachung

Die Stromsignale I1 bis I3 werden in der DS 5 summiert. Bei einem 3-Leiter-Zähler muß im Regelfall die Stromsumme = 0 sein. Wird hier ein vorgegebener Grenzwert überschritten, so wird ein drittes Fehlersignal erzeugt. Gegebenenfalls kann bei einem 4-Leiter-Zähler zu der Stromsumme auch der Nulleiterstrom In hinzuaddiert werden. Dies gilt selbstverständlich für Netze, bei denen der Nulleiterstrom auch erfaßt wird. Zusätzlich kann auch ein Vergleich der Stromsumme des Signalkanals b mit der Stromsumme des dritten Signalkanals c erfolgen. Dadurch ist eine weitere Überwachung möglich, wobei im Fehlerfall ein viertes Fehlersignal erzeugt wird.

### Weitere Funktionen

Gegebenenfalls kann zur Überprüfung der den Multiplexern 13a bis 13cc vorgeschalteten Stromsensoren diesen eine weitere Prüfeinrichtung vorgeschaltet sein, so daß auch dieser Eingangsbereich der Signalerfassung einer Überwachung unterliegt. Eine derartige Überprüfung kann beispielsweise bei der Zählerablesung durchgeführt oder in festen Zeitintervallen wiederholt werden. Es ist dabei denkbar, daß die vorgeschaltete Prüfeinrichtung über die Schnittstelle 11 einen Datenaustausch mit dem Zähler 1 durchführt, so daß eine automatische und schnelle Funktionskontrolle möglich ist.

Eine weitere Zusatzfunktion kann auch dadurch gegeben sein, daß beim Ausfall eines der Signale einer Phase oder eines Meßkanals automatisch auf einen Notbetrieb umgeschaltet wird, wobei das fehlende Signal über einen anderen Signalkanal erfaßt wird. Diese Umschaltung kann gegebenenfalls in Abhängigkeit von einem der obengenannten Fehlersignale ausgelöst werden und ist zweckmäßigerweise in der bereits obengenannte Logik realisiert. Diese Umschaltung ist insbesondere bei internen Fehlern im Zähler von Interesse.

Durch die umfangreichen Plausibilitätskontrollen ist eine sichere Fehlerlokalisierung und verbesserte Betriebsführung gegenüber dem Stand der Technik gegeben, wobei wesentliche Funktionen des Zählers 1 geprüft werden. Die Anzeige oder Signalisierung der Fehlersignale erfolgt zweckmäßigerweise durch die Anzeigemittel 9 oder über die Schnittstelle 11.

Selbstverständlich sind Merkmale der einzelnen Ausführungen oder Varianten miteinander kombinierbar oder untereinander austauschbar, ohne daß der Grundgedanke der vorliegenden Idee verlassen wird. Wesentlich hierfür ist, daß eine redundante Signalerfassung Verwendung findet, die eine Fehlererfassung für die jeweiligen Meßkanäle und gegebenenfalls einen Hilfsbetrieb erlaubt.

## Patentansprüche

1. Elektrizitätszähler (1) mit drei Signalkanälen (a,b,c), die auf eine digitale Signalverarbeitungseinrichtung (5) geführt sind, wobei jeder Signalkanal (a,b,c) folgende Mittel umfaßt:
- einen Multiplexer (13a bis 13c), auf dessen Eingänge mittels Wandler erfaßte Strom- und/oder Spannungssignale (I1 bis I3 bzw. U1 bis U3) eines elektrischen Verbrauchers geschaltet sind, und
- einen dem Multiplexer (13a bis 13c) nachgeschalteten Sigma-Delta-Modulator (17a bis 17c),
- wobei auf den ersten und zweiten Signalkanal (a,b) die Spannungs- bzw. Stromsignale (U1 bis U3 bzw. I1 bis I3) und auf den dritten Signalkanal (c) dieselben Spannungs- und Stromsignale (I1 bis I3 bzw. U1 bis U3) und gegebenenfalls weitere Signale (In, Uh) geschaltet sind, und
- wobei in der digitalen Signalverarbeitungseinrichtung (5) ein Vergleich von Daten gleicher Signale (U1 bis U3, I1 bis I3) erfolgt, die von unterschiedlichen Signalkanälen (a,c bzw. b,c) bereitgestellt werden, und beim Auftreten einer Signalabweichung, die einen vorgegebenen ersten Wert überschreitet, ein erstes Fehlersignal erzeugt wird.

2. Elektrizitätszähler nach Anspruch 1, wobei zwischen dem dritten Multiplexer (13c) und der Signalverarbeitungseinrichtung (5) ein vierter Multiplexer (13cc) geschaltet ist, auf dessen weiteren Eingängen gegebenenfalls nochmals die weiteren Signale (In, Uh) geführt sind.

3. Elektrizitätszähler nach einem der Ansprüche 1 oder 2, wobei zumindest den ersten drei Multiplexern (13a bis 13c) zusätzlich ein Erd- oder Massepotential als Eingangssignal zugeführt ist.

4. Elektrizitätszähler nach einem der Ansprüche 1 bis 3, wobei eines der weiteren Signale eine Hilfsspannung (Uh), ein Hilfs- oder Nulleiterstrom (In), ein Temperatur- oder ein Spannungssignal ist.

5. Elektrizitätszähler nach einem der Ansprüche 1 bis 4, wobei in der Signalverarbeitungseinrichtung (5) mit Hilfe eines Oszillators, insbesondere eines Quarzoszillators, die Netzfreauenz der erfaßten Spannungssignale (U1 bis U3) gemessen wird und bei Überschreiten eines vorgegebenen Frequenzgrenzwertes ein zweites Fehlersignal erzeugt wird.

6. Elektrizitätszähler nach einem der Ansprüche 1 bis 5, wobei von den im zweiten Signalkanal (b) erfaßten Stromsignalen (I1 bis I3) eine erste Summe gebildet und mit einem Stromgrenzwert verglichen und bei Überschreiten des Stromgrenzwertes ein drittes Fehlersignal erzeugt wird.

7. Elektrizitätszähler nach Anspruch 6, wobei zu der ersten Summe der Ströme zusätzlich ein als weiteres Signal erfaßter Nulleiterstrom (In) hinzuaddiert ist.

8. Elektrizitätszähler nach Anspruch 6 oder 7, wobei von den dem dritten Multiplexer (13c) zugeführten Stromsignalen (I1 bis I3) und gegebenenfalls einem als weiteres Signal erfaßter Nulleiterstrom (In) analog zur ersten Summe eine zweite Summe gebildet und mit der ersten Summe verglichen wird und bei Überschreiten eines vorgegebenen Summengrenzwertes ein viertes Fehlersignal erzeugt wird.

9. Elektrizitätszähler nach einem der vorhergehenden Ansprüche, wobei die Multiplexer (13a bis 13cc) miteinander synchronisiert sind.

10. Elektrizitätszähler nach einem der vorhergehenden Ansprüche, wobei die Anzahl der Eingänge der jeweiligen Multiplexer (13 a bis 13cc) für die Erfassung von dreiphasigen Messwerten ausgebildet ist.

11. Elektrizitätszähler nach einem der vorhergehenden Ansprüche, wobei zwischen den Sigma-Delta-Modulatoren (17a bis 17c) und der digitalen Signalverarbeitungseinrichtung (5) jeweils ein Dezimationsfilter (19a bis 19 c) geschaltet ist.

12. Elektrizitätszähler nach einem der vorhergehenden Ansprüche, wobei in der digitalen Signalverarbeitungseinrichtung (5) in Abhhängigkeit zumindest eines der Fehlersignale ein Ausfall einer der Signalkanäle (a,b,c) erfaßt wird und im Fehlerfall das dadurch jeweils fehlende Signal über einen der intakten Signalkanäle (a,b,c) erfaßt wird.

## Claims

1. Electricity meter (1) having three signal channels (a, b, c) that are fed to a digital signal processor (5), wherein each signal channel (a, b, c) comprises the following means:
- a multiplexer (13a to 13c) to whose inputs are connected current signals and/or voltage signals (I1 to I3 or U1 to U3, respectively), detected by means of converters, of an electrical load, and
- a sigma-delta modulator (17a to 17c) connected downstream of the multiplexer (13a to 13c),
- wherein there is connected to the first and second signal channels (a, b) the voltage signals or current signals (U1 to U3 or I1 to I3, respectively) and to the third signal channel (c) the same voltage signals and current signals (I1 to I3 or U1 to U3) and, optionally, further signals (In, Uh), and
- wherein, in the digital signal processor (5), data of identical signals (U1 to U3, I1 to I3) that are provided by different signal channels (a, c or b, c, respectively) are compared and a first fault signal is generated if a signal deviation occurs that exceeds a preset first value.

2. Electricity meter according to Claim 1, wherein there is connected between the third multiplexer (13c) and the signal processor (5) a fourth multiplexer (13cc) to whose further inputs the further signals (In, Uh) are again optionally fed.

3. Electricity meter according to one of Claims 1 or 2, wherein an earth or chassis potential is additionally fed as input signal to at least the first three multiplexers (13a to 13c).

4. Electricity meter according to one of Claims 1 to 3, wherein one of the further signals is an auxiliary voltage (Uh), an auxiliary current or neutral current (In), a temperature signal or a voltage signal.

5. Electricity meter according to one of Claims 1 to 4, wherein the mains frequency of the voltage signals detected (U1 to U3) is measured in the signal processor (5) with the aid of an oscillator, in particular a quartz oscillator, and, if a preset frequency limit value is exceeded, a second fault signal is generated.

6. Electricity meter according to one of Claims 1 to 5, wherein a first sum is formed from the current signals (I1 to I3) detected in the second signal channel (b) and compared with a current limit value and, if the current limit value is exceeded, a third fault signal is generated.

7. Electricity meter according to Claim 6, wherein a neutral current (In) detected as a further signal is additionally added to the first sum of the currents.

8. Electricity meter according to Claim 6 or 7, wherein a second sum is formed from the current signals (I1 to I3) fed to the third multiplexer (13c) and, optionally, a neutral current (In) detected as a further signal, analogously to the first sum, and is compared with the first sum and, if a preset sum limit value is exceeded, a fourth fault signal is generated.

9. Electricity meter according to one of the preceding claims, wherein the multiplexers (13a to 13cc) are synchronized with one another.

10. Electricity meter according to one of the preceding claims, wherein the number of inputs of the respective multiplexers (13a to 13cc) is designed to detect three-phase measured values.

11. Electricity meter according to one of the preceding claims, wherein a decimation filter (19a to 19c) is connected in each case between the sigma-delta modulators (17a to 17c) and the digital signal processor (5).

12. Electricity meter according to one of the preceding claims, wherein a failure of one of the signal channels (a, b, c) is detected in the digital signal processor (5) as a function of at least one of the fault signals and, in the event of a fault, the signal missing in each case as a result is detected via one of the intact signal channels (a, b, c).

## Revendications

1. Compteur électrique (1) ayant trois canaux de signaux (a, b, c) qui sont envoyés à un dispositif de traitement de signal numérique (5), chaque canal de signal (a, b, c) comprenant les moyens suivants :
- un multiplexeur (13a à 13c) sur les entrées duquel sont appliqués des signaux de courants et/ou de tensions (I1 à I3 ou U1 à U3), détectés au moyen de transformateurs, d'un consommateur d'électricité, et
- un modulateur sigma-delta (17a à 17c) branché du côté aval du multiplexeur (13a à 13c),
- des signaux de tensions ou de courants (U1 à U3 ou I1 à I3) étant appliqués sur le premier et sur le deuxième canal de signal (a, b), les mêmes signaux (I1 à I3 ou U1 à U3) et éventuellement d'autres signaux (In, Uh) étant appliqués sur le troisième canal de signal (c), et
- une comparaison de données de mêmes signaux (U1 à U3, I1 à I3) qui sont fournis par différents canaux de signaux (a, c ou b, c) s'effectuant dans le dispositif de traitement de signal numérique (5) et un premier signal d'erreur étant produit lors de l'apparition d'un écart de signal qui dépasse une première valeur prédéterminée.

2. Compteur électrique selon la revendication 1, dans lequel il est branché entre le troisième multiplexeur (13c) et le dispositif de traitement de signal numérique (5) un quatrième multiplexeur (13cc) sur les autres entrées duquel les autres signaux (In, Uh) sont éventuellement envoyés encore une fois.

3. Compteur électrique selon l'une des revendications 1 ou 2, dans lequel un potentiel de terre ou de masse est envoyé en plus comme signal d'entrée au moins aux trois premiers multiplexeurs (13a à 13c).

4. Compteur électrique selon l'une des revendications 1 à 3, dans lequel l'un des autres signaux est une tension auxiliaire (Uh), un courant auxiliaire ou de conducteur neutre (In), un signal de température ou un signal de tension.

5. Compteur électrique selon l'une des revendications 1 à 4, dans lequel la fréquence de réseau des signaux de tensions détectés (U1 à U3) est mesurée dans le dispositif de traitement de signal numérique (5) à l'aide d'un oscillateur, notamment d'un oscillateur à quartz, et un deuxième signal d'erreur est produit lors du dépassement d'une valeur limite de fréquence prédéterminée.

6. Compteur électrique selon l'une des revendications 1 à 5, dans lequel une première somme est formée à partir des signaux de courants (I1 à I3) détectés dans le deuxième canal de signal (b) et est comparée à une valeur limite de courant et un troisième signal de courant est produit lors du dépassement de la valeur limite de courant.

7. Compteur électrique selon la revendication 6, dans lequel un courant de conducteur neutre (In) détecté comme autre signal est ajouté en plus à la première somme des courants.

8. Compteur électrique selon la revendication 6 ou 7, dans lequel une deuxième somme est formée, comme la première somme, à partir des signaux de courants (I1 à I3) envoyés au troisième multiplexeur (13c) et éventuellement d'un courant de conducteur neutre (In) détecté comme autre signal et est comparée à la première somme et un quatrième signal d'erreur est produit lors du dépassement d'une valeur limite de somme prédéterminée.

9. Compteur électrique selon l'une des revendications précédentes, dans lequel les multiplexeurs (13a à 13cc) sont synchronisés entre eux.

10. Compteur électrique selon l'une des revendications précédentes, dans lequel le nombre des entrées des multiplexeurs respectifs (13a à 13cc) est conçu pour la détection de valeurs mesurées triphasées.

11. Compteur électrique selon l'une des revendications précédentes, dans lequel un filtre de décimation (19a à 19c) est branché à chaque fois entre les modulateurs sigma-delta (17a à 17c) et le dispositif de traitement de signal numérique (5).

12. Compteur électrique selon l'une des revendications précédentes, dans lequel une panne d'un des canaux de signaux (a, b, c) est détectée dans le dispositif de traitement de signal numérique (5) en fonction d'au moins l'un des signaux d'erreurs et, en cas d'erreur, le signal alors respectivement manquant est détecté par l'intermédiaire d'un des canaux de signaux (a, b, c) intacts.
